# EUROPEAN PATENT APPLICATION

(11) **EP 4 797 896 A1**
(43) Date of publication of application: **26.08.2026**
(21) Application number: 26159641.5
(22) Date of filing: 19.02.2026
(51) Int. Cl.: H05K 7/20

(54) **COOLING DEVICE AND MOTOR VEHICLE**

(30) Priority: 19.02.2025 CN 202510186039
(71) Applicant: Valeo Automotive Air Conditioning Hubei Co., Ltd., Jingzhou, Hubei 434007 (CN)
(72) Inventor: SUN, Jianqi, Shashi, 434000 (CN); LI, Xiaojie, Shashi, 434000 (CN); ZUO, Sheng, Shashi, 434000 (CN); PENG, Zijun, Shashi, 434000 (CN); LIU, Zhigang4, Shashi, 434000 (CN); FAN, Changsheng, Shashi, 434000 (CN)
(74) Representative: Valeo Powertrain Systems

(57) **Abstract**

The present disclosure provides a cooling device and a motor vehicle. The cooling device comprises: a cooling device housing with a cavity inside; a fluid inlet and a fluid outlet, which are arranged on the cooling device housing, a heat exchange fluid entering the cavity via the fluid inlet and flowing out via the fluid outlet; and at least two layers of flow disturbing parts arranged in the cavity. The present disclosure reduces a fin height of the flow disturbing part of each layer by providing at least two layers of flow disturbing parts inside the cavity, has a manufacturing process that is easy to implement, and has a low manufacturing cost; moreover, the flow disturbing part with the fin height reduced can be manufactured with a smaller fin pitch, such that the flow disturbing part has more fins, to increase a contact area between the flow disturbing part and the heat exchange fluid, effectively improving the heat dissipation/cooling efficiency of the cooling device. Compared with technical solutions in the prior art of a single layer of a flow disturbing part, at least two layers of flow disturbing parts may have a greater overall height, which may further increase the contact area between the heat exchange fluid and the flow disturbing part, improving the heat dissipation/cooling efficiency of the cooling device.

## Description

### Technical Field

The present disclosure relates to a cooling device and to a motor vehicle comprising the cooling device, in particular to a cooling device with a low cost, a small pressure drop and high heat dissipation efficiency.

### Background Art

An inverter module in a high-voltage control system mainly converts DC power supplied by a storage battery into AC power to meet the power requirements of an electric motor. The inverter module generates heat during operation, and in order to ensure proper operation and extend the life of the inverter module, a cooling device is required to dissipate heat from the inverter module. In existing inverter cooling devices, heat-dissipating fins are usually provided which have a fin height of approximately 5.5 mm - 7 mm and a fin pitch of approximately 1.5 mm or more, so that not only is a heat dissipation effect poor and a pressure drop large, but also the higher fins are not easy to process and manufacture which results in high manufacturing costs.

Thus, those skilled in the art are committed to developing a novel cooling device to solve the abovementioned shortcomings in the prior art.

### Summary of the Invention

An objective of the present disclosure is to provide a cooling device, which has at least two layers of flow disturbing parts inside a cavity of a cooling device housing to reduce a fin height of the flow disturbing part of each layer, has a manufacturing process that is easy to implement, and has a low manufacturing cost; moreover, the flow disturbing part with the fin height reduced can be manufactured with a smaller fin pitch, such that the flow disturbing part has more fins, increasing a contact area between the flow disturbing part and heat exchange fluid, effectively improving the heat dissipation/cooling efficiency of the cooling device. Compared with technical solutions in the prior art of a single layer of a flow disturbing part, at least two layers of flow disturbing parts provided by the present disclosure may have a greater overall height, which may further increase the contact area between the heat exchange fluid and the flow disturbing part, improving the heat dissipation/cooling efficiency of the cooling device. Furthermore, by setting the fin pitch of the flow disturbing part to gradually decrease in a flow direction of the heat exchange fluid, a flow resistance near the fluid inlet is effectively reduced, reducing a pressure loss; moreover, as the distance from the fluid inlet increases, the fin pitch gradually decreases such that the flow disturbing part may be provided with more fins, increasing the contact area between the fluid and the fins, improving the heat dissipation effect.

The present disclosure provides a cooling device, the cooling device comprising: a cooling device housing, comprising: a first cover plate; a second cover plate, which is stacked on the first cover plate in a first direction and forms a cavity with the first cover plate; and a fluid inlet and a fluid outlet, which are arranged on the cooling device housing, a heat exchange fluid entering the cavity via the fluid inlet and flowing out of the cavity via the fluid outlet, wherein the cooling device further comprises at least two layers of flow disturbing parts stacked in the cavity in the first direction.

The cooling device according to the present disclosure may also have one or more of the following features individually or in combination.

In one or more embodiments, the cooling device comprises two layers of flow disturbing parts.

In one or more embodiments, a partition plate is provided between two adjacent layers of flow disturbing parts.

In one or more embodiments, at least one of the partition plate, the first cover plate and the second cover plate is provided with a positioning part.

In one or more embodiments, the flow disturbing part of each layer comprises at least one flow disturbing member.

In one or more embodiments, the flow disturbing member has multiple fins.

In one or more embodiments, the fins of flow disturbing members of flow disturbing parts located at different layers have different fin heights and/or different fin pitches.

In one or more embodiments, the fin pitch of the fins of the flow disturbing part is gradually reduced in a flow direction of the heat exchange fluid.

In one or more embodiments, the flow disturbing part comprises three flow disturbing members.

In one or more embodiments, the partition plate comprises three partition sub-plates, which are respectively correspondingly arranged between flow disturbing members of adjacent layers.

In one or more embodiments, the cooling device further comprises an inlet connector and an outlet connector, which are respectively mounted to the fluid inlet and the fluid outlet, and in fluid communication with the cavity.

In one or more embodiments, the fluid inlet and the fluid outlet are arranged on the first cover plate.

The present disclosure also provides a motor vehicle, comprising: an inverter module; and the cooling device as previously described, the cooling device being used for cooling the inverter module.

### Brief Description of the Drawings

Fig. 1 is a three-dimensional drawing of a cooling device according to a first embodiment of the present disclosure;
Fig. 2 is a three-dimensional drawing of the cooling device according to the first embodiment of the present disclosure, viewed from another angle of view;
Fig. 3 is an exploded view of the cooling device according to the first embodiment of the present disclosure;
Fig. 4 is a three-dimensional drawing of a first cover plate according to the first embodiment of the present disclosure;
Fig. 5 is a three-dimensional drawing of the first cover plate according to the first embodiment of the present disclosure, viewed from another angle of view;
Fig. 6 is a three-dimensional drawing of a second cover plate according to the first embodiment of the present disclosure;
Fig. 7 is a cutaway three-dimensional drawing of a cooling device housing according to the first embodiment of the present disclosure, wherein the cooling device housing comprises the first cover plate and the second cover plate;
Fig. 8 is a three-dimensional drawing of components in the cooling device housing according to the first embodiment of the present disclosure, wherein the components in the cooling device housing comprise two layers of a flow disturbing part and a partition plate between the flow disturbing parts;
Fig. 9 is a three-dimensional drawing of a flow disturbing member according to the first embodiment of the present disclosure;
Fig. 10 is a partially enlarged view of the flow disturbing member according to the first embodiment of the present disclosure;
Fig. 11 is a three-dimensional drawing of a fin in the flow disturbing member according to the first embodiment of the present disclosure;
Fig. 12 is a three-dimensional drawing of the partition plate according to the first embodiment of the present disclosure;
Fig. 13 is a cutaway three-dimensional drawing of the cooling device according to the first embodiment of the present disclosure;
Fig. 14 is a three-dimensional drawing of components in a cooling device housing according to a second embodiment of the present disclosure;
Fig. 15 is a three-dimensional drawing of components in a cooling device housing according to a third embodiment of the present disclosure;
Fig. 16 is a three-dimensional drawing of a cooling device housing according to a fourth embodiment of the present disclosure.

### Detailed Description of the Invention

Ways of implementing the present disclosure are described below through specific embodiments; based on the content disclosed herein, those skilled in the art will be able to easily understand other advantages and effects of the present disclosure.

It should be noted that all of the structures, proportions and sizes, etc., depicted in the drawings attached hereto are merely intended to complement the content disclosed herein, being offered for a person skilled in the art to understand and peruse, and are not intended to define limiting conditions for implementation of the present disclosure, and therefore do not have any substantive technical meaning. Any structural modifications, changes to proportional relationships or adjustments to size, which have no impact on the effects and objectives achievable by the present disclosure, shall still fall within the scope of coverage of the technical content disclosed herein. Moreover, words such as "up" and "a" cited herein are merely intended to clarify the description, not to limit the scope of implementation of the present disclosure; changes or adjustments to relationships which do not substantively alter the technical content shall also be regarded as being within the scope of implementation of the present disclosure.

The present disclosure provides a cooling device that may be used for electrical equipment (such as an inverter module). Specific embodiments of the present disclosure are explained in detail below with reference to the accompanying drawings.

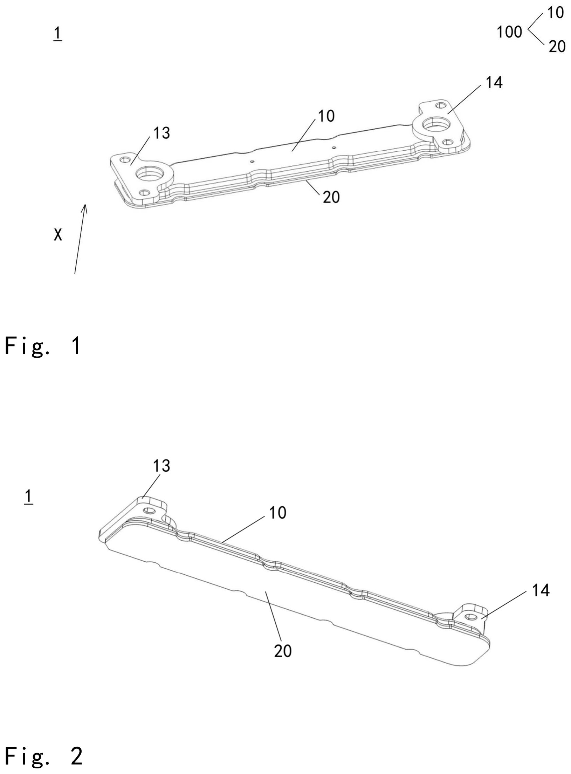

Referring to Figs. 1 to 7, the cooling device 1 comprises a cooling device housing 100, the cooling device housing 100 comprising a first cover plate 10 and a second cover plate 20, wherein the second cover plate 20 may be stacked on the first cover plate 10 in a first direction X, and forms a cavity with the first cover plate 10. The cooling device housing 100 is provided with a fluid inlet 11 and a fluid outlet 12, and a heat exchange fluid (which may be referred to simply as a fluid, for example being a cooling liquid) may enter the cavity via the fluid inlet 11 and flow out of the cavity via the fluid outlet 12, to form a fluid circuit. The cooling device 1 may further comprise at least two layers of flow disturbing parts 30, which are arranged in the cavity and stacked in the first direction X (the present disclosure is mainly illustrated by, but not limited to, two layers of flow disturbing parts 30). Such an arrangement not only can effectively reduce the height of the flow disturbing part 30 of each layer, but also the manufacturing process is easy to implement, and the manufacturing cost is low; moreover, the flow disturbing part 30 with the height reduced can be manufactured with a smaller fin pitch D (to be discussed later), such that the flow disturbing part 30 may have more fins, to change a flow direction of fluid that enters the cavity, causing full mixing thereof, and increasing a contact area between the flow disturbing part 30 and the fluid, effectively improving the heat dissipation/cooling efficiency of the cooling device 1. Compared with technical solutions in the prior art of only a single layer of a flow disturbing part 30 provided in a cooling device 1, at least two layers of flow disturbing parts 30 provided by the present disclosure may have a greater overall height, which may further increase the contact area between the fluid and the flow disturbing part 30, improving the heat dissipation/cooling efficiency of the cooling device 1.

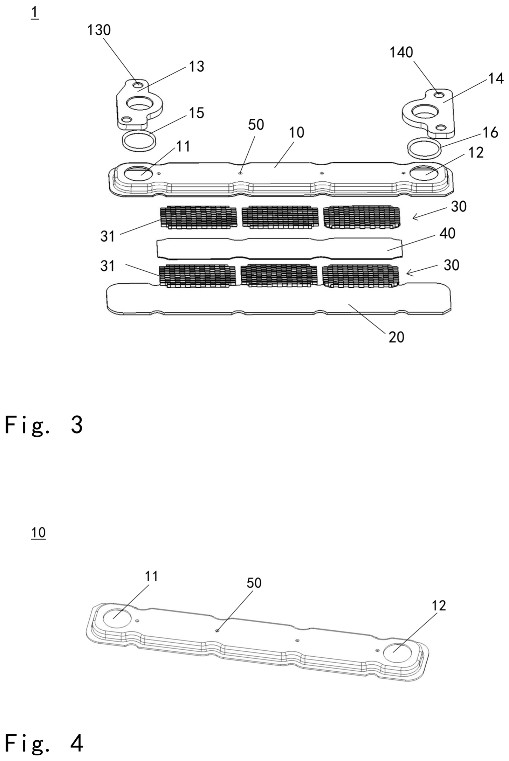

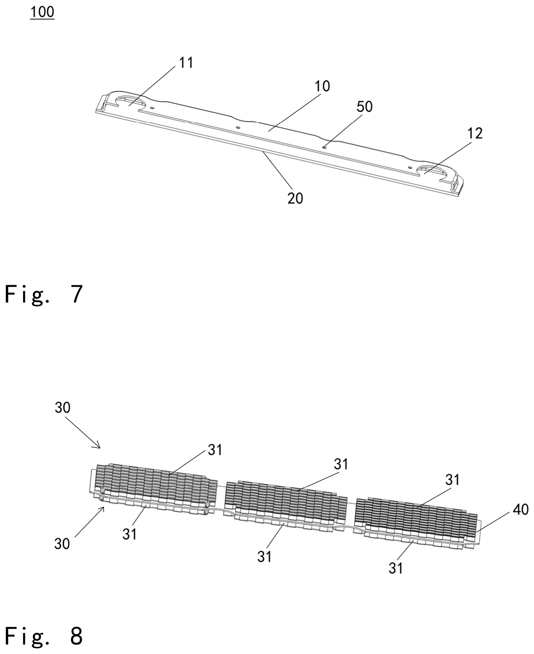

In particular, as shown in Figs. 4 to 6, the first cover plate 10 and the second cover plate 20 may be substantially plate-shaped, wherein the first cover plate 10 may have a recess projecting outwardly away from the second cover plate 20, and the second cover plate 20 may be a flat plate. When the first cover plate 10 is stacked in the first direction X and fixed (e.g. by riveting combined with brazing) to the second cover plate 20, the second cover plate 20 may seal the recess in the first cover plate 10 and form a cavity, as shown in Fig. 7. The stacked plate design described above reduces the weight of the cooling device 1, simplifies the structure of the cooling device 1, facilitates mounting and reduces costs. Of course, the present disclosure is not limited to the above structure; for example, the second cover plate 20 may also have a recess projecting outwardly away from the first cover plate 10, so long as when the first cover plate 10 is stacked and fixed on the second cover plate 20, the two cover plates may seal the recess of the other and form a cavity.

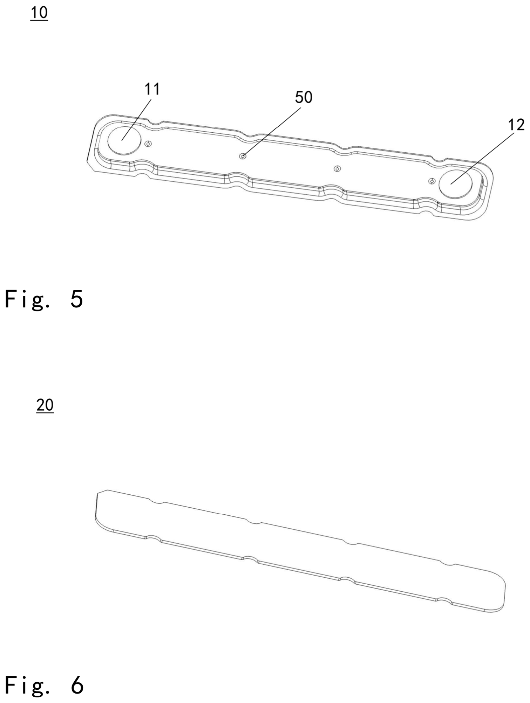

In one embodiment, as shown in Figs. 4 and 5, a first cover plate 10 is provided with a fluid inlet 11 and a fluid outlet 12 respectively at two ends thereof, to enable a heat exchange fluid to enter the cavity via the fluid inlet 11 and heat to be removed from the cavity via the fluid outlet 12, to realise a heat exchange function. Of course, the present disclosure is not limited to this; for example, a fluid inlet 11 and a fluid outlet 12 may also be arranged on a second cover plate 20, or two openings may be respectively arranged on the first cover plate 10 and the second cover plate 20, as long as heat exchange fluid is able to enter the cavity via the fluid inlet 11 and leave the cavity via the fluid outlet 12.

Referring to Figs. 3, 8 and 12, two layers of flow disturbing parts 30 may be provided in the cavity of the cooling device housing 100; compared to the prior art, the height of the flow disturbing part 30 of each layer is lower to facilitate manufacture and reduce costs; moreover, the flow disturbing part 30 with a reduced height can be made with a smaller fin pitch D, thereby increasing the number of fins; furthermore, the overall height of the two layers of flow disturbing parts 30 can be set to be greater than the height of a single layer of a flow disturbing part in the prior art, so that a contact area between the heat exchange fluid and the flow disturbing part 30 can be increased, effectively improving the heat dissipation/cooling efficiency of the cooling device 1.

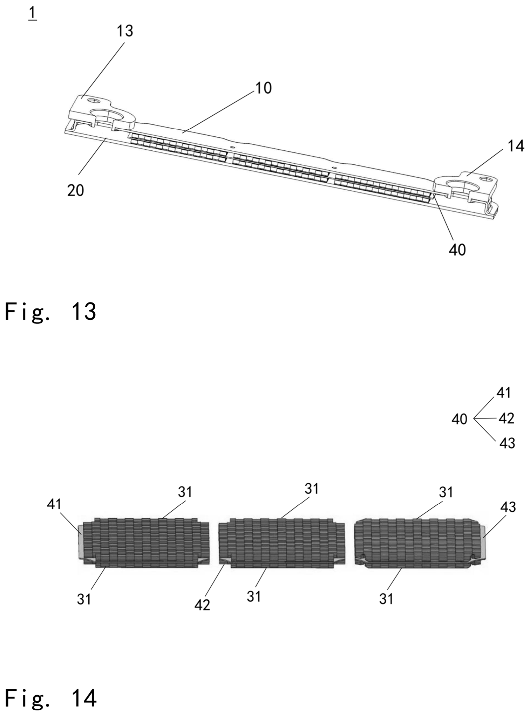

In one embodiment, a flow disturbing part 30 may be arranged and fixed in a cavity between the fluid inlet 11 and the fluid outlet 12 (as shown in Fig. 13), such that the flow of the heat exchange fluid entering the cavity may be sufficiently disturbed by the flow disturbing part 30. The flow disturbing part 30 of each layer may comprise three flow disturbing members 31 that are spaced apart from each other, as shown in Figs. 3 and 8; the flow disturbing members 31 that are spaced apart from each other are discontinuous in the direction of flow of the fluid, and where the heat exchange fluid can be buffered and redistributed at the discontinuities, fluid resistance is reduced and a pressure loss is reduced, and, compared to a larger flow disturbing member 31, multiple flow disturbing members 31 that are spaced apart from each other are easier to manufacture, and when a fault occurs, easy to repair and replace, reducing maintenance costs. In addition, by setting the fin pitch D of each flow disturbing member 31, the fluid pressure drop can be further reduced while ensuring heat dissipation efficiency.

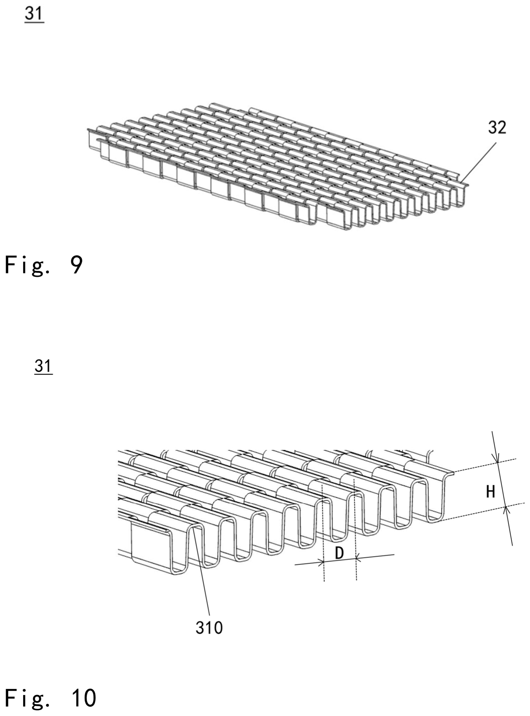

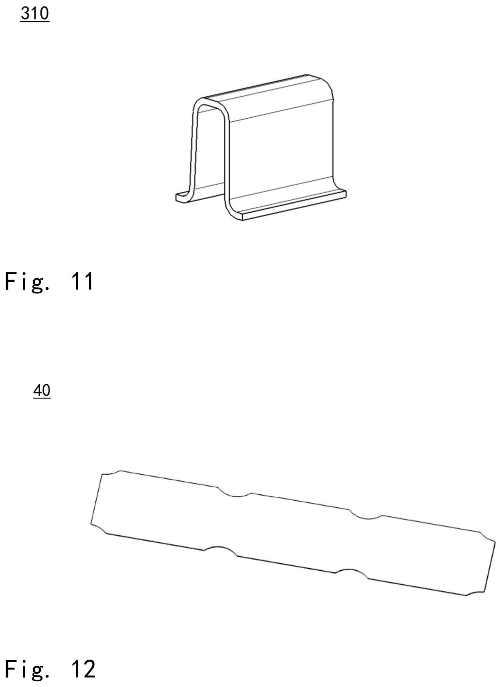

In particular, referring to Figs. 9 to 10, the flow disturbing member 31 may comprise multiple rows of fin units 32; each fin unit 32 may be substantially wave-shaped, and two adjacent rows of fin units 32 are staggered from each other to enhance the effect of disturbing the flow of fluid. The fin unit 32 comprises multiple fins 310 connected end to end, and each fin 310 may be substantially an inverted U-shape (as shown in Fig. 11); such an arrangement not only simplifies the structure and facilitates manufacturing, but can also cause the heat exchange fluid flowing through the flow disturbing member 30 to form turbulent flow and fully contact the flow disturbing member 31, effectively improving the heat dissipation/cooling efficiency of the cooling device. The fin pitch D described in the present disclosure is defined as a distance between middle positions of the tops of two adjacent fins 310 in the fin unit 32, and the fin height H is defined as the height of the fin 310, as shown in Fig. 10. The fin height H of the flow disturbing part 30 described in the present disclosure may be set to be 2 mm - 5 mm, and preferably, the fin height H may be set to be 2.5 mm, 3 mm, 3.5 mm, 4 mm or 4.5 mm; compared to a flow disturbing part 30 with a fin height of approximately 5.5 mm - 7 mm in the prior art, the flow disturbing part 30 of the present disclosure, or the flow disturbing member 31, has a lower fin height H, is easy to manufacture and can reduce manufacturing costs. In a scenario in which the fin height H of the flow disturbing member 31 is reduced, the fin pitch D of the flow disturbing member 31 may be manufactured to have a smaller size (such as 1 mm), such that the flow disturbing member 31 may have more fins 310, effectively changing a flow direction of fluid that enters the cavity, causing full mixing thereof, and increasing a contact area between the flow disturbing member 31 and the heat exchange fluid, effectively improving the heat dissipation/cooling efficiency of the cooling device 1.

In one embodiment, three flow disturbing members 31 in the flow disturbing part 30 of each layer may have the same fin height H to facilitate manufacturing. The fin height H of flow disturbing parts 30 of two adjacent layers can be set to be the same or different according to requirements. Of course, the present disclosure is not limited to this; for example, the fin heights H of the flow disturbing members 31 may also be set to be different, and in particular the fin heights H of the three flow disturbing members 31 of the flow disturbing part 30 of each layer may be set to gradually increase in the flow direction of the heat exchange fluid, which can increase the contact area between the heat exchange fluid and the fins 310 in a scenario in which the temperature of the heat exchange fluid gradually increases, to further improve the heat dissipation efficiency of the cooling device 1.

In one embodiment, a fin pitch D of fins 310 of a flow disturbing part 30 may be set to gradually decrease in a flow direction of the heat exchange fluid, such that a flow resistance of low temperature heat exchange fluid near a fluid inlet 11 is small, which can reduce a pressure loss (i.e. reducing a pressure drop); the temperature of the heat exchange fluid increases gradually as the distance thereof from the fluid inlet 11 increases, but the gradually decreasing fin pitch D enables the flow disturbing member 31 to have a greater number of fins 310, to increase the contact area between the fluid and the fins 310, improving the heat dissipation effect. That is, the arrangement of the fin pitch D of the flow disturbing part 30 gradually decreasing in the flow direction of the heat exchange fluid can reduce the pressure drop of the fluid while increasing the heat dissipation efficiency of the cooling device 1.

In one embodiment, each flow disturbing member 31 may have a uniform fin pitch D; moreover, a flow disturbing member 31 near a fluid inlet 11 may have a larger fin pitch D, and a flow disturbing member 31 near a fluid outlet 12 may have a smaller fin pitch D, and a flow disturbing member 31 between the two may have a fin pitch D of an intermediate size. Such an arrangement not only can improve the heat dissipation efficiency of the cooling device 1 and reduce a fluid pressure drop, but also can facilitate manufacture of the flow disturbing member 31, reducing manufacturing costs.

Referring to Figs. 3, 8 and 12, the cooling device 1 may further comprise a partition plate 40; the partition plate 40 may be a plate-shaped structure made of a thermally conductive material, arranged in the cooling device housing 100, and located between two adjacent layers of flow disturbing parts 30, for pre-positioning the flow disturbing parts 30 to facilitate fixedly mounting the flow disturbing parts 30. In one embodiment, flow disturbing parts 30 on two sides of a partition plate 40 may be symmetrically distributed relative to the partition plate 40, to provide a more uniform flow of fluid on both sides of the partition plate 40 to improve heat transfer efficiency. In the present embodiment, three flow disturbing members 31 may be arranged and fixed (e.g. brazed) on a first side (an upper side as shown in Fig. 8) of the partition plate 40, and another three flow disturbing members 31 may be arranged and fixed (e.g. brazed) on a second side (a lower side as shown in Fig. 8) of the partition plate 40, wherein the first side is arranged opposite the second side, and heat dissipation efficiency of the cooling device 1 can be improved and the pressure drop reduced by setting the fin height H and/or the fin pitch D of each flow disturbing member 31. Preferably, at least one positioning part (not shown) may be provided on the first and/or second side of the partition plate 40 for positioning the flow disturbing member 31. In one embodiment, a positioning part may be, for example, a projection formed by a stamping process, and four projections may be provided on a first side and a second side of a partition plate 40, respectively, so that the positions of three flow disturbing members 31 on the first side and the positions of three flow disturbing members 31 on the second side can be precisely defined.

Referring to Figs. 4 and 5, the first cover plate 10 and/or the second cover plate 20 may also be provided with multiple positioning parts 50, respectively, projecting toward the interior of the cavity (the present disclosure shows only positioning parts 50 arranged on the first cover plate 10, but not positioning parts on the second cover plate 20), used to limit the flow disturbing part 30 or, in other words, the flow disturbing member 31. In one embodiment, the positioning part 50 may be formed on a first cover plate 10 and/or a second cover plate 20, for example, by a stamping process, to facilitate manufacturing. The present embodiment is mainly illustrated by taking a first cover plate 10 provided with four positioning parts 50 as an example; however, the present disclosure is not limited to this.

Referring to Fig. 3, the cooling device 1 may also comprise an inlet connector 13 and an outlet connector 14. The inlet connector 13 and the outlet connector 14 are respectively fixedly mounted to a fluid inlet 11 and a fluid outlet 12, and are in fluid communication with a cavity, to enable the cooling device 1 to quickly dock to an external component, realising circulation of fluid. The inlet connector 13 and the outlet connector 14 may be substantially T-shaped; a substantially central position of this T shape may be provided with an opening in fluid communication with the fluid inlet 11 or the fluid outlet 12, and a radial dimension of this opening may be substantially the same as a radial dimension of the fluid inlet 11 or the fluid outlet 12.

In one embodiment, in order to sealingly connect the opening of the inlet connector 13 to the fluid inlet 11, the cooling device 1 may be provided with an inlet solder pad 15 between the inlet connector 13 and the first cover plate 10. The inlet solder pad 15 is substantially annular in shape and may surround the opening of the inlet connector 13 and the fluid inlet 11, so that the opening of the inlet connector 13 may be connected sealingly to the fluid inlet 11 by soldering, such as brazing, to prevent fluid leakage. In addition, the cooling device 1 may be further provided with an outlet solder pad 16 between the outlet connector 14 and the first cover plate 10. The outlet solder pad 16 is substantially annular in shape and may surround the opening of the outlet connector 14 and the fluid outlet 12, so that the opening of the outlet connector 14 may be connected sealingly to the fluid outlet 12 by soldering, such as brazing, to prevent fluid leakage.

Referring to Figs. 1, 2 and 3, the inlet connector 13 may further be provided with a mounting hole 130 on two sides of the opening thereof; when the inlet connector 13 is mounted on the first cover plate 10, portions of the inlet connector 13 provided with the mounting hole 130 may protrude from a periphery of the cooling device housing 100, so as to facilitate fixedly mounting the cooling device 1 to an external component such as a vehicle body, by means of a fastening element (such as a screw or a bolt). Likewise, the outlet connector 14 may also be provided with a mounting hole 140 on two sides of the opening thereof; when the outlet connector 14 is mounted on the first cover plate 10, portions of the outlet connector 14 provided with the mounting hole 140 may protrude from a periphery of the cooling device housing 100, so as to facilitate fixedly mounting the cooling device 1 to an external component such as a vehicle body, by means of a fastening element (such as a screw or a bolt).

The process of mounting the cooling device 1 is briefly described below in conjunction with the accompanying drawings.

When the cooling device 1 is mounted, two layers of flow disturbing parts 30 may first be fixedly mounted (e.g. brazed) to two sides of the partition plate 40 (as shown in Fig. 8), and then fixedly mounted (e.g. brazed) to the second cover plate 20, and the first cover plate 10 is then overlaid on the structure shown in Fig. 8 and fixedly mounted (e.g. brazed) to the second cover plate 20, and the structure shown in Fig. 8 is clamped between the first cover plate 10 and the second cover plate 20; finally, the inlet connector 13 and the outlet connector 14 are soldered to the first cover plate 10 by means of the inlet solder pad 15 and the outlet solder pad 16, respectively, and the openings of the inlet connector 13 and the outlet connector 14 are respectively in fluid connection with the fluid inlet 11 and the fluid outlet 12, thus completing the mounting of the cooling device 1.

Of course, the present disclosure is not limited to the above-described mounting steps; for example, it is also possible to first fixedly mount (e.g. braze) a layer of a flow disturbing part 30 to one side of the partition plate 40, and then fixedly mount (e.g. braze) the flow disturbing part 30 mounted to the partition 40 to the second cover plate 20, and clamp this flow disturbing part 30 between the second cover plate 10 and the partition plate 40, then fixedly mount (e.g. braze) another layer of a flow disturbing part 30 to the other side of the partition plate 40, and then mount the first cover plate 10 and components such as the inlet connector 13 and the outlet connector 14, to complete the mounting of the cooling device 1; alternatively, it is also possible to first fixedly mount one layer of a flow disturbing part 30 to the second cover plate 20, and then sequentially mount the partition plate 40, the other layer of a flow disturbing part 30, the first cover plate 10, and the inlet connector 13 and the outlet connector 14, etc. in a stacked manner.

Different embodiments of the present disclosure will be described below. To simplify description, the emphasis below is on providing a detailed description of differences between embodiments, without describing identical parts again. In addition, identical elements in the embodiments of the present disclosure are marked with identical labels, to facilitate comparison of the embodiments.

Fig. 14 shows internal components in a cooling device housing 100 of the cooling device 1 according to a second embodiment of the present disclosure. Differences between the second embodiment and the first embodiment only lie in the structure of the partition plate 40. In particular, in the second embodiment, the partition plate 40 may comprise three partition sub-plates 41, 42 and 43 that are spaced apart from each other, respectively correspondingly arranged between flow disturbing members 31 of adjacent layers, so that heat exchange fluid can be redistributed at the spacings, fully mixing the fluid in the upper and lower layers of the partition plate 40, further reducing flow resistance of the heat exchange fluid; moreover, compared to a larger partition sub-plate 40, the smaller partition sub-plates 41, 42 and 43 are easier to manufacture, and easy to repair and replace.

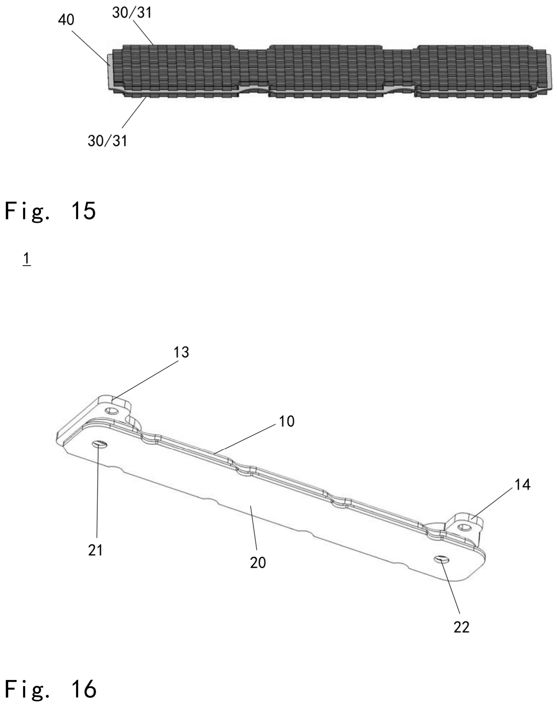

Fig. 15 shows internal components in a cooling device housing 100 of the cooling device 1 according to a third embodiment of the present disclosure. Differences between the third embodiment and the first embodiment only lie in the structure of the flow disturbing part 30. In particular, in the third embodiment, each layer of a flow disturbing part 30 comprises only one flow disturbing member 31, and this flow disturbing member 31 covers most of a first side or a second side of a partition plate 40; such an arrangement can facilitate mounting and save on mounting time. Preferably, two layers of flow disturbing parts 30 may be symmetrically distributed relative to the partition plate 40, to provide a more uniform flow of fluid on both sides of the partition plate 40 to improve heat transfer efficiency.

Fig. 16 shows a cooling device 1 of a fourth embodiment. Differences between the fourth embodiment and the first embodiment only lie in two communicating holes 21 and 22 being provided on the second cover plate 20, the two communicating holes 21 and 22 mainly being used for fluid connection to another cooling device, to form a dual-layer cooling device, so that, by means of clamping required cooling components between the two cooling devices, a heat dissipation effect thereof can be enhanced.

Although the above embodiments of the present disclosure are mainly illustrated by taking two adjacent layers of flow disturbing parts 30 being symmetrically distributed with respect to a partition plate 40 as an example, the present disclosure is not limited to this; for example, flow disturbing parts 30 on both sides of the partition plate 40 may also be asymmetrically distributed, and, more specifically, for example, the number and size of the flow disturbing members 31 on the first side of the partition plate 40 may be different from the number and size of the flow disturbing members 31 on the second side thereof, as long as the cooling device 1 is internally provided with multiple layers of low-height flow disturbing parts 30 to reduce a process difficulty and improve the heat dissipation effect.

The above embodiments of the present disclosure are mainly illustrated taking flow disturbing members 31 of the flow disturbing part 30 of each layer having the same fin height H as an example; however, the present disclosure is not limited to this; for example, each flow disturbing member 31 arranged in the cooling device 1 may be set to have a different fin height H and/or fin pitch D, as long as the cooling device 1 is internally provided with multiple layers of low-height flow disturbing parts 30 to reduce a process difficulty and improve the heat dissipation effect.

The above embodiments of the present disclosure are mainly illustrated by taking two layers of flow disturbing parts 30 being provided in the cooling device housing 100 as an example; however, the present disclosure is not limited to this; for example, three layers of flow disturbing parts 30 may also be provided in the cooling device housing 100, as long as the manufacturing process difficulty of the flow disturbing part 30 can be reduced and the heat dissipation efficiency can be improved.

In addition, the above embodiments of the present disclosure are mainly illustrated by taking a partition plate 40 being provided between two adjacent layers of flow disturbing parts 30 as an example; however, the present disclosure is not limited to this; for example, another structure or direct contact may also be provided between two adjacent layers of flow disturbing parts 30, as long as the manufacturing process difficulty of the flow disturbing part 30 can be reduced and the heat dissipation efficiency can be improved.

In summary, the cooling device provided by the present disclosure reduces a fin height of the flow disturbing part of each layer by providing at least two layers of flow disturbing parts inside the cavity of the cooling device housing, has a manufacturing process that is easy to implement, and has a low manufacturing cost; moreover, the flow disturbing part with the fin height reduced can be manufactured with a smaller fin pitch, such that the flow disturbing part has more fins, increasing a contact area between the flow disturbing part and the heat exchange fluid, effectively improving the heat dissipation/cooling efficiency of the cooling device. Compared with technical solutions in the prior art of only a single layer of a flow disturbing part, at least two layers of flow disturbing parts provided by the present disclosure may have a greater overall height, which may further increase the contact area between the heat exchange fluid and the flow disturbing part, improving the heat dissipation/cooling efficiency of the cooling device. Furthermore, by setting the fin pitch of the flow disturbing part to gradually decrease in a flow direction of the heat exchange fluid, a flow resistance near the fluid inlet is effectively reduced, reducing a pressure loss; moreover, as the distance from the fluid inlet increases, the fin pitch gradually decreases such that the flow disturbing part may be provided with more fins, increasing the contact area between the fluid and the fins, improving the heat dissipation effect.

The present disclosure also provides a motor vehicle, which may comprise an inverter module and the aforementioned cooling device 1, and this cooling device 1 may effectively dissipate heat from the inverter module. In particular, the cooling device 1 may be provided with a mounting plate (not shown) fixed to the cooling device housing 100 for mounting the inverter module, to dissipate heat from the inverter module. In one embodiment, a mounting plate may be substantially plate-shaped and may be fixed to a second cover plate by brazing, etc.; that is, the mounting plate and an inlet connector 13 and an outlet connector 14 are respectively located on two sides of a cooling device housing 100; such an arrangement may increase a contact area between the mounting plate and a cooling device 1, improving the heat dissipation efficiency of an inverter module, for example.

Demonstrative ways of implementing the cooling device and the motor vehicle provided in the present disclosure have been described above with reference to preferred embodiments, but those skilled in the art will understand that as long as the concept of the present disclosure is not deviated from, various changes and modifications could be made to the specific embodiments above, and various technical features and structures set forth in the present disclosure could be combined in various ways, without exceeding the scope of protection of the present disclosure, which is specified by the attached claims.

## Claims

1. Cooling device (1), the cooling device (1) comprising:
a cooling device housing (100), comprising:
a first cover plate (10);
a second cover plate (20), which is stacked on the first cover plate (10) in a first direction (X) and forms a cavity with the first cover plate (10); and
a fluid inlet (11) and a fluid outlet (12), which are arranged on the cooling device housing (100), a heat exchange fluid entering the cavity via the fluid inlet (11) and flowing out of the cavity via the fluid outlet (12),
wherein the cooling device (1) further comprises at least two layers of flow disturbing parts (30) stacked in the cavity in the first direction (X).

2. Cooling device (1) according to Claim 1, wherein a partition plate (40) is provided between two adjacent layers of flow disturbing parts (30).

3. Cooling device (1) according to Claim 1, wherein at least one of the partition plate (40), the first cover plate (10) and the second cover plate (20) is provided with a positioning part (50).

4. Cooling device (1) according to Claim 1, wherein the flow disturbing part (30) of each layer comprises at least one flow disturbing member (31).

5. Cooling device (1) according to Claim 4, wherein the flow disturbing member (31) has multiple fins (310), the fins (310) of flow disturbing members (31) of flow disturbing parts (30) located at different layers having different fin heights (H) and/or different fin pitches (D).

6. Cooling device (1) according to Claim 5, wherein the fin pitch (D) of the fins (310) of the flow disturbing part (30) is gradually reduced in a flow direction of the heat exchange fluid.

7. Cooling device (1) according to Claim 4, wherein the flow disturbing part (30) comprises three flow disturbing members (31).

8. Cooling device (1) according to Claim 7, wherein the partition plate (40) comprises three partition sub-plates (41, 42, 43), which are respectively correspondingly arranged between flow disturbing members (31) of adjacent layers.

9. Cooling device (1) according to Claim 1, wherein the cooling device (1) further comprises an inlet connector (13) and an outlet connector (14), which are respectively mounted to the fluid inlet (11) and the fluid outlet (12), and in fluid communication with the cavity.

10. Cooling device (1) according to Claim 1, wherein the fluid inlet (11) and the fluid outlet (12) are arranged on the first cover plate (10).

11. Motor vehicle, the motor vehicle comprising:
an inverter module; and
the cooling device (1) according to any one of Claims 1 - 10, the cooling device (1) being used for cooling the inverter module.
